# EUROPEAN PATENT SPECIFICATION

(11) **EP 1 742 107 B1**
(45) Date of publication and mention of the grant of the patent: **05.06.2013**
(21) Application number: 06253575.2
(22) Date of filing: 07.07.2006
(51) Int. Cl.: G03F 7/033, H05K 3/06

(54) **Photoimageable composition**
Fotoempfindliche Zusammensetzung
Composition photosensible

(30) Priority: 08.07.2005 CN 200510084116
(43) Date of publication of application: 10.01.2007
(73) Proprietor: Eternal Chemical Co., Ltd., Kaohsiung (TW)
(72) Inventor: Yang, Ming-Hsiung, Kaohsiung (TW); Mao, Hui-Kuan, Kaohsiung (TW); Tsai, Feng-Chih, Kaohsiung (TW)
(74) Representative: Wright, Simon Mark

(56) References cited:
- WO-A-2005/036267

## Description

### Field of the Invention

The present invention relates to a negative-acting photoimageable composition. The photoimageable composition is developable in an alkaline aqueous solution and may be used as a photoresist in the processes of alkaline etching, gold plating, and electroless nickel immersion gold (ENIG), e.g. for the manufacture of printed circuit boards.

### Background of the Invention and Description of the Prior Art

WO 2005/036267 describes a photosensitive resin composition comprising (a) a binder polymer based on a copolymer containing benzyl (meth)acrylate as a building block, (b) a photopolymerisable compound, and (c) a photopolymerisation initiator.
The development of photoimageable compositions, such as those disclosed in USP5609991, USP5698370, and USP5576145, usually focuses on improving hydrophobicity by the addition of multifunctional monomers or oligomers, such as styrene or maleic anhydride copolymers, having a higher hydrophobicity, thereby enhancing the chemical resistance of the photoimageable compositions and obtaining good effects in alkaline etching, gold plating, etc., for the manufacture of printed circuit boards. However, these prior art techniques formally encounter disadvantages such as brittleness, much shorter holding time, and easy generation of scum after development, which influence the yield of printed circuit boards.

To address the above problems, the inventors have, through extensive studies, found that the polymeric binder resulting from polymerization of a particular acrylate as the essential polymerized unit can enhance the chemical resistance of the resultant photoimageable composition, decrease the impact of the above-mentioned undesired side effects, and greatly improve the yield.

### Summary Of the Invention

The object of the invention is to provide a negative-acting photoimageable composition, which can be used as a photoresist in the manufacture of printed circuit boards.

The photoimageable composition of the invention comprises:
A) a polymeric binder;
B) a photopolymerizable compound; and
C) a photoinitiator.
The polymeric binder of component (A) contains (as a polymerized unit) at least one monomer having the structure of formula (1): 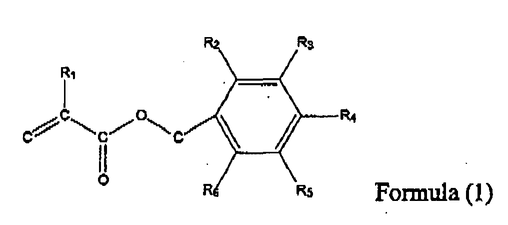 wherein, R₁ is H or methyl; and
R₂, R₃, R₄, R₅ and R₆ independently represent H, a halogen, or a substituted or unsubstituted C₁ to C₁₀ alkyl.

The amount of the monomer of Formula (1) is from 5 to 35 wt% based on the total weight of the polymeric binder.

### Detailed Description of the Invention

The percentages regarding the compositions used herein are all percentages by weight, unless indicated otherwise.

To achieve the development in an alkaline aqueous solution, the component (A) of the present composition, a polymeric binder, should have sufficient acid functionality and have an acid value of at least 70 KOH mg/g, preferably (at least) 100 KOH mg/g, and more preferably more than 130 KOH mg/g and/or up to 250 KOH mg/g. The acid functionality is typically carboxylic acid functionality, but may also include, for example, sulfonic acid functionality and/or phosphoric acid functionality.

In the composition of the invention, the amount of component (A), the polymeric binder, is from 30 to 80 wt%, preferably from 45 to 75 wt%, such as from 50 to 60 wt% based on the total weight of the composition, and has weight average molecular weights ranging from 20,000 to 200,000, preferably from 35,000 to 120,000, such as from 45,000 to 100,000.

Therefore, the polymeric binder of the invention can have polymerized units derived from an acid functional monomer and a non-acid functional monomer as the polymerized units. Without particular limitation, suitable acid functional monomers can be those known to persons having ordinary skill in the art, including, for example, but not being limited to, acrylic acid, methacrylic acid, maleic acid, fumaric acid, citric acid, 2-acrylamido-2-methylpropanesulfonic acid, 2-hydroxyethylacryloylphosphate, 2-hydroxypropylacryloylphosphate, and/or 2-hydroxy-α-acryloylphosphate. According to an embodiment of the invention, preferred acid functional monomers include acrylic acid and/or methacrylic acid. The polymeric binder of the invention may contain one or more acid functional monomers.

According to the present invention, the non-acid functional monomer copolymerized with the acid functional monomer can comprise at least one monomer having the structure of formula (1): 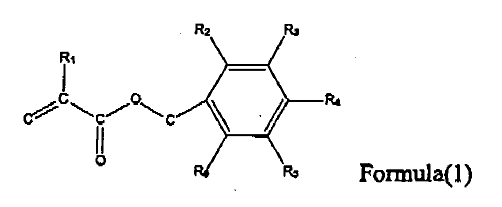 wherein, R₁ is H or methyl; and R₂, R₃, R₄, R₅ and R₆ independently represent H, a halogen (i.e., fluorine, chlorine or bromine), or a substituted or unsubstituted C₁-C₁₀ alkyl. Preferably R₁ is H and/or each (and preferably all) of R₂ to R₆ is (are) H.

According to one embodiment of the invention, the monomer having the structure of formula (1) is benzyl (meth)acrylate.

The etching resistance of a photoimageable composition depends on the Double Bond Equivalents (DBE), the greater the number of which, the better the etching resistance could be obtained. The DBE of a benzene ring is 4, which may provide an excellent etching resistance. By including a benzene ring in the structure of formula(1), the chemical resistance of the compound of formula (1) can be enhanced, and therefore the alkali-resistant ability can be improved when the development occurs in an alkaline aqueous solution. Therefore, the adhesion after the development is improved and, as a result, a good alkaline etching resistance is obtained.

The amount of the monomers having the structure of formula (1) is from 5 to 35 wt%, preferably from 10 to 25 wt% (on the basis of 100 wt% of the polymeric binder solids).

Suitable non-acid functional monomers polymerizable with the acid functional monomers include acrylates, such as methyl acrylate, methyl methacrylate, hydroxyethyl acrylate, hydroxyethyl methacrylate, ethyl acrylate, ethyl methacrylate, n-butyl acrylate, n-butyl methacrylate, t-butyl acrylate, t-butyl methacrylate, n-hexyl acrylate, n-hexyl methacrylate, octyl acrylate, octyl methacrylate, 2-ethoxyethyl acrylate, 2-ethoxyethyl methacrylate, 2-ethylhexyl acrylate, 1,5-pentanediol diacrylate, N,N-diethylaminoethyl acrylate, ethylene glycol diacrylate, 1,3-propanediol diacrylate, decanediol acrylate, decanediol dimethacrylate, 1,4-cyclohexanediol diacrylate, 2,2-dimethylolpropane diacrylate, glycerol diacrylate, tripropanediol diacrylate, glycerol triacrylate, 2,2-di(p-hydroxyphenyl)-propane dimethacrylate, triethylene glycol dimethacrylate, polyoxypropyltrimethylol propane triacrylate, ethylene glycol dimethacrylate, butylene glycol dimethacrylate, 1,3-propanediol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenylethylene-1,2-dimethacrylate, pentaerythritol tetramethacrylate, trimethylolpropane trimethacrylate, 1,5-pentanediol dimethacrylate, and 1,4-benzenediol dimethacrylate; substituted or unsubstituted styrenes, such as 2-methyl styrene and vinyl toluene; and/or vinyl esters, such as vinyl acrylate and vinyl methacrylate. According to the embodiment of the invention, preferred non-acid functional monomers include methyl acrylate, methyl methacrylate, hydroxyethyl acrylate, hydroxyethyl methacrylate, ethyl acrylate, ethyl methacrylate, n-butyl acrylate, n-butyl methacrylate, t-butyl acrylate, t-butyl methacrylate, n-hexyl acrylate, n-hexyl methacrylate, octyl acrylate, and/or octyl methacrylate.

The photopolymerizable compound of the component (B) of the invention is generally a monomer or short-chain oligomer with an ethylenically unsaturated functional group, particularly α,β-ethylenically unsaturated functional group, including monofunctional, difunctional, or multifunctional groups. The component (B) suitable for the invention includes, but is not limited to, the acid functional monomers and non-acid functional monomers described above as useful for producing the polymeric binder, of which the non-acid functional monomers are preferred. The polymerizable monomers with di- or multifunctional groups may include, but are not limited to, triethylene glycol dimethacrylate, polyoxypropyltrimethylol propane triacrylate, ethylene glycol dimethacrylate, butylene glycol dimethacrylate, 1,3-propanediol dimethacrylate, 1,2,4-butanetriol trimethacrylate, 2,2,4-trimethyl-1,3-pentanediol dimethacrylate, pentaerythritol trimethacrylate, 1-phenylethylene-1,2-dimethacrylate, pentaerythritol tetramethacrylate, trimethylolpropane trimethacrylate, 1,5-pentaneol dimethacrylate, diallyl fumarate, styrene, 1,4-benzenediol dimethacrylate, 1,4-diisopropenyl benzene, 1,3,5-triisopropenyl benzene, ethoxy modified trimethylolpropane triacrylate, trimethylolpropane triacrylate, trimethylolpropane trimethacrylate and standard bisphenol-A-epoxy diacrylate. Suitable oligomers include urethane acrylate oligomers, aliphatic urethane oligomers, and epoxy acrylate oligomers. These photopolymerizable compounds may be used in the resin composition of the invention alone or in the form of a mixture of two or more of these compounds. The amount of the photopolymerizable compound is generally in the range of 5 to 50 wt%, preferably in the range of 10 to 40 wt%, based on the total weight of the composition.

The component (C) of the present composition is a photoinitiator, which can provide free radicals upon exposure to light, and/or initiate polymerization through transmission of the free radicals. The species of photoinitiators are well known to persons having ordinary skill in the art. The photoinitiator suitable for the invention includes, for example, but is not limited to, n-phenyl glycine, 9-phenylacridine, benzoins, benzyldimethylketal, imidazole dimers such as 2,4,5-triarylimidazole dimers (e.g., 2-(o-chlorophenyl)-4,5-diphenylimidazole dimer, 2-(o-chlorophenyl)-4,5-di(m-methoxy phenyl) imidazole dimer, 2-(o-chlorophenyl)-4,5-diphenylimidazole dimer, 2-(o-methoxy phenyl)-4,5-diphenylimidazole dimer, 2-(p-methoxy phenyl)-4,5-diphenylimidazole dimer, 2,4-di(p-methoxy phenyl)-5-phenylimidazole dimer, 2-(2,4-dimethoxy phenyl)-4,5-diphenylimidazole dimer, 2-(p-methylmercapto phenyl)-4,5-diphenylimidazole dimer). Furthermore, acridine-comprising compounds, suitably 9-phenylacridine homologs, for example, those disclosed in U.S. Patent No. 5217845, are incorporated herein by reference, are also useful as a photoinitiator for the invention.

Specifically, the amount of the photoinitiator is from 1.5 to 20 wt%, preferably from 2 or 3 to 5, 10 or 15 wt%.

The composition of the invention may optionally comprise an additive, component (D), well known to persons having ordinary skill in the art, including, for example, but not being limited to, one or more of dyes, stabilizers, couplers, flexibilizing agents, fillers, or a combination thereof.

The photoimageable composition of the invention can be used as a photoresist in the manufacture of printed circuit boards. For example, a photoimageable composition layer formed from a liquid composition or transferred from a dry film is placed on the copper surface of a copper-clad board, and covered with a photomask. The photoimageable composition layer is exposed to actinic radiation, which will polymerize the monomers in the exposed area to form a cross-linked structure resistant to a developer. Moreover, the non-radiated area is developed with a diluted alkaline aqueous solution, for example, 1% aqueous sodium carbonate solution. Since the alkaline aqueous solution can promote the formation of salts with the carboxyl groups contained in the polymeric binder, the binder may become soluble and removable. After the development, the uncovered copper foil is etched and removed with an alkaline etchant, such as a mixture solution of copper-amine complex salt and aqueous ammonia, so as to form a printed circuit. Finally, the remaining photoresist layer is removed by a stripper, such as sodium hydroxide.

The present invention will be further illustrated in the Examples below, which are not intended to limit the scope of the invention in any way.

### Examples and Comparative Examples

### Synthesis of polymer A-1

224 g methacrylic acid, 288 g methyl methacrylate, 104 g butyl acrylate, 120 g benzyl acrylate, and 64 g butyl methacrylate were placed in a four-neck round bottom flask, with 575 g 2-butanone and 175 g isopropanol as the solvent, stirred, and heated to reflux. A mixture of 100 g 2-butanone as a solvent and 3 g 2,2'-azobisisobutyro nitrile as an initiator was added dropwise for 1 hour. The reaction was refluxed for 0.5 hours. 50 g 2-butanone and 1 g 2,2'-azobisisobutyro nitrile were added and refluxed for 2 hours. 150 g 2-butanone and 4 g 2,2'-azobisisobutyro nitrile were then added, and refluxed for 6 hours. The reaction was cooled to afford the polymeric binder A-1, with a viscosity (25°C) of 9800 and an average molecular weight of about 82000.

### Synthesis of polymer A-2

224 g methacrylic acid, 304 g methyl methacrylate, 136 g butyl acrylate, 120 g benzyl methacrylate, and 88 g 2-ethylhexyl acrylate were put into a four-neck round bottom flask, with 575 g 2-butanone and 175 g isopropanol as the solvent, stirred, and heated to reflux. A mixture of 100 g 2-butanone as a solvent and 3 g 2,2'-azobisisobutyro nitrile as an initiator was added dropwise for 1 hour. The reaction was refluxed for 0.5 hours. 50 g 2-butanone, 1 g 2,2'-azobisisobutyro nitrile and 48 g styrene were added and refluxed for 2 hours. 150 g 2-butanone and 4 g 2,2'-azobisisobutyro nitrile were then added, and refluxed for 6 hours. The reaction was cooled to afford the polymeric binder A-2, with a viscosity (at 25°C) of 11500 and an average molecular weight of about 60000.

### Synthesis of polymer A-3

224 g methacrylic acid, 288 g methyl methacrylate, 104 g butyl acrylate and 64 g butyl methacrylate were put into a four-neck round bottom flask, with 575 g 2-butanone and 175 g isopropanol as the solvent, stirred, and heated to reflux. A mixture of 100 g 2-butanone, 3 g 2,2'-azobisisobutyro nitrile and 120 g styrene was then added dropwise over 1 hour, and refluxed for 0.5 hours. 50 g 2-butanone and 1 g 2,2'-azobisisobutyro nitrile were added and refluxed for 2 hours. 150 g 2-butanone and 4 g 2,2'-azobisisobutyro nitrile were then added, and refluxed for 6 hours. Thereafter, the reaction was cooled to afford the polymeric binder A-3, with a viscosity (at 25°C) of 11000 and an average molecular weight of about 80000.

### Synthesis of polymer A-4

224 g methacrylic acid, 304 g methyl methacrylate, 136 g butyl acrylate and 88 g 2-ethylhexyl acrylate were placed into a four-neck round bottom flask, with 575 g 2-butanone and 175 g isopropanol as the solvent, stirred, and heated to reflux. A mixture of 100 g 2-butanone as a solvent and 3 g 2,2'-azobisisobutyro nitrile as an initiator and 48 g styrene was added dropwise over 1 hour, and refluxed for 0.5 hours. 50 g 2-butanone and 1 g 2,2'-azo-bisisobutyronitrile were added and refluxed for 2 hours. 150 g 2-butanone and 4 g 2,2'-azobisisobutyro nitrile were then added and refluxed for 6 hours. Thereafter, the reaction was cooled to afford the polymeric binder A-4, with a viscosity (at 25°C) of 10000 and an average molecular weight of about 70000.

### Synthesis of polymer A-5

224 g methacrylic acid, 368 g methyl methacrylate, 104 g butyl acrylate, 40 g benzyl acrylate and 64 g butyl methacrylate were placed into a four-neck round bottom flask, stirred and heated to reflux. A mixture of 100 g 2-butanone as a solvent and 3 g 2,2'-azobisisobutyro nitrile as an initiator were added dropwise over 1 hour, and refluxed for 0.5 hours. 50 g 2-butanone and 1 g 2,2'-azobisisobutyro nitrile were added and refluxed for 2 hours. 150 g 2-butanone and 4 g 2,2'-azobisisobutyro nitrile were then added and refluxed for 6 hours. Thereafter, the reaction was cooled to afford the polymeric binder A-5, with a viscosity (at 25°C) of 8000 and an average molecular weight of about 45000.

### Synthesis of polymer A-6

224 g methacrylic acid, 206 g methyl methacrylate, 104 g butyl acrylate, 202 g benzyl acrylate and 64 g butyl methacrylate were placed into a four-neck round bottom flask, with 575 g 2-butanone and 175 g isopropanol as the solvent, stirred, and heated to reflux. A mixture of 100 g 2-butanone as a solvent and 3 g 2,2'-azobisisobutyronitrile as an initiator were added dropwise over 1 hour, and refluxed for 0.5 hours. 50 g 2-butanone and 1 g 2,2'-azobisisobutyro nitrile were added and refluxed for 2 hours. 150 g 2-butanone and 4 g 2,2'-azobisisobutyro nitrile were then added and refluxed for 6 hours. Thereafter, the reaction was cooled to afford the polymeric binder A-6, with a viscosity (at 25°C) of 7000 and an average molecular weight of about 100000.

### Synthesis of polymer A-7

224 g methacrylic acid, 388 g methyl methacrylate, 104 g butyl acrylate, 20 g benzyl acrylate and 64 g butyl methacrylate were placed into a four-neck round bottom flask, with 575 g 2-butanone and 175 g isopropanol as the solvent, stirred, and heated to reflux. A mixture of 100 g 2-butanone as a solvent and 3 g 2,2'-azobisisobutyro nitrile as an initiator was added dropwise over 1 hour, and refluxed for 0.5 hours. 50 g 2-butanone and 1 g 2,2'-azobisisobutyro nitrile were added and refluxed for 2 hours. 150 g 2-butanone and 4 g 2,2'-azobisisobutyro nitrile were then added and refluxed for 6 hours. Thereafter, the reaction was cooled to afford the polymeric binder A-7, with a viscosity (at 25°C) of 5500 and an average molecular weight of about 65000.

**TABLE 1**

| | A-1 | | A-2 | | A-3 | | A-4 | | A-5 | | A-6 | | A-7 | |
|---|---|---|---|---|---|---|---|---|---|---|---|---|---|---|
| methacrylic acid | 224 g | 27.7% | 224 g | 24.1% | 224 g | 27.7% | 224 g | 27.7% | 224 g | 27.7% | 224 g | 27.7% | 224 g | 27.7% |
| Methyl methacrylate | 288 g | 35.6% | 304 g | 32.8% | 288 g | 35.6% | 304 g | 37.6% | 368 g | 45.5% | 206 g | 25.5% | 388 g | 48.0% |
| butyl acrylate | 104 g | 12.9% | 136 g | 14.7% | 104 g | 12.9% | 136 g | 16.8% | 104 g | 12.9% | 104 g | 12.9% | 104 g | 12.9% |
| benzyl acrylate | 120 g | 14.9% | 120 g | 12.9% | - | - | - | - | 40 g | 5.0% | 202 g | 25.0% | 20 g | 2.5% |
| butyl methacrylate | 64 g | 7.9% | - | - | 64 g | 7.9% | - | - | 64 g | 7.9% | 64 g | 7.9% | 64 g | 7.9% |
| 2-ethylhexyl acrylate | - | - | 88 g | 9.5% | - | - | 88 g | 10.9% | - | - | - | - | - | - |
| Styrene | - | - | 48 g | 5.2% | 120 g | 14.9% | 48 g | 5.9% | - | - | - | - | - | - |
| 2,2'-Azobisisobutyronitrile | 8 g | 1.0% | 8 g | 0.9% | 8 g | 1.0% | 8 g | 1.0% | 8 g | 1.0% | 8 g | 1.0% | 8 g | 1.0% |
| Total | 808 g | 100% | 928 g | 100% | 808 g | 100% | 808 g | 100% | 808 g | 100% | 808 g | 100% | 808 g | 100% |

The photoimageable compositions of the invention and the Comparative Examples were obtained by blending the components in the amounts as shown in table 2, and stirring the blend uniformly with an agitator, with the temperature controlled at 20~40°C.

**TABLE 2: formulations of photoimageable compositions**

| Photoimageable composition (g) | | Examples | | | | | | Comparative Examples | | | | | | | |
|---|---|---|---|---|---|---|---|---|---|---|---|---|---|---|---|
| | | 1 | 2 | 3 | 4 | 5 | 6 | 1 | 2 | 3 | 4 | 5 | 6 | 7 | 8 |
| a) polymeric binder | A-1 | 60 g (100% solids) | -- | 60 g (100% solids) | -- | -- | -- | -- | -- | -- | -- | -- | -- | -- | -- |
| | A-2 | -- | 60 g (100% solids) | -- | 60 g (100% solids) | -- | -- | -- | -- | -- | -- | -- | -- | -- | -- |
| | A-3 | -- | -- | -- | -- | -- | -- | -- | -- | 60 g (100% solids) | -- | 60 g (100% solids) | -- | 60 g 100% solids) | -- |
| | A-4 | -- | -- | -- | -- | -- | -- | -- | -- | -- | 60 g (100% solids) | -- | 60 g (100% solids) | -- | 60 g (100% solids) |
| | A-5 | -- | -- | -- | -- | 60 g (100% solids) | -- | -- | -- | -- | -- | -- | -- | -- | -- |
| | A-6 | -- | -- | -- | -- | -- | 60 g (100% solids) | -- | -- | -- | -- | -- | -- | -- | -- |
| | A-7 | -- | -- | -- | -- | -- | -- | 60 g (100% solids) | 60 g (100% solids) | -- | -- | -- | -- | -- | -- |
| (b) photo-polymerizable compound | B1 | 20 | 20 | -- | -- | 20 | 20 | 20 | -- | 20 | 20 | -- | -- | -- | -- |
| | B2 | 15.6 | 15.6 | -- | -- | 15.6 | 15.6 | 15.6 | -- | 15.6 | 15.6 | -- | -- | -- | -- |
| | B3 | -- | -- | 35.6 | -- | -- | -- | -- | 35.6 | -- | -- | 35.6 | 35.6 | -- | -- |
| | B4 | -- | -- | -- | 35.6 | -- | -- | -- | -- | -- | -- | -- | -- | 35.6 | 35.6 |
| | B5 | 10 | 10 | -- | -- | 10 | 10 | 10 | -- | 10 | 10 | -- | -- | -- | -- |
| (c) photo-initiator | C1 | 0.1 | 0.1 | 0.1 | 0.1 | 0.1 | 0.1 | 0.1 | 0.1 | 0.1 | 0.1 | 0.1 | 0.1 | 0.1 | 0.1 |
| | C2 | 3.6 | 3.6 | 3.6 | 3.6 | 3.6 | 3.6 | 3.6 | 3.6 | 3.6 | 3.6 | 3.6 | 3.6 | 3.6 | 3.6 |
| (d)additive | D1 | 0.65 | 0.65 | 0.65 | 0.65 | 0.65 | 0.65 | 0.65 | 0.65 | 0.65 | 0.65 | 0.65 | 0.65 | 0.65 | 0.65 |
| | D2 | 0.05 | 0.05 | 0.05 | 0.05 | 0.05 | 0.05 | 0.05 | 0.05 | 0.05 | 0.05 | 0.05 | 0.05 | 0.05 | 0.05 |

| | | | | | | | | | | | | | | | |
|---|---|---|---|---|---|---|---|---|---|---|---|---|---|---|---|
| Note: B1: ethoxy modified trimethylolpropane triacrylate (PHOTOMER®4155, Cognis) B2: aliphatic urethane oligomer B3: trimethylolpropane triacrylate (ETERMER®231, ETERNAL CHEMICAL) B4: trimethylolpropane trimethacrylate (ETERMER®331, ETERNAL CHEMICAL) B5: standard bisphenol-A-epoxy diacrylate (ETERCURE®621A-80, ETERNAL) C1: n-phenyl glycine (NPG, Hampford) C2: imidazole dimer (BCIM, Black Gold) D1: coupler: colorless crystal violet D2: peacock green dye | | | | | | | | | | | | | | | |

### Characterization Test:

(1) A formulated varnish formulation, after being mixed uniformly, was coated to form a coating with a thickness of 38 microns.
(2) The copper surface of a copper-clad board was pre-treated with a chemical microetching process, and the extent of the microetching was 1.0~1.5 micron (40~60 microinches).
(3) Pressed film: The hot roller temperature was 110±5°C; the pressure was 0.3 MPa (3 kgw/cm²); the speed was 1.5 m/min.
(4) Exposure: The process was carried out using a Stouffer 21 at photoresist step 8 (copper step 9), after 50% development points have been developed. The line widths of the test negatives for the adhesion test were 20, 25, 30, 35, 40, 45, 50, 60, 70, 80, 90, and 100 microns.
(5) Development: 1% aqueous Na₂CO₃ solution was used; the temperature was 28±0.3°C; the development point was 50% BP.
(6) Alkaline etching test: flask test; pH=9.5; temperature=50°C.
   A pre-cut sample sheet was immersed into an etching solution, i.e. the alkaline etching solution for etching copper, which was adjusted by aqueous ammonia to a pH of 9.5, for 2 minutes, and then taken out immediately, rinsed with a large amount of water, and dried. The sample sheet was detected by microscopy for the thinnest photoresist circuit remaining on the copper surface.
(7) Gold plating test: pH=6.0; temperature=60°C; the concentration of gold, [Au⁺]=2 g/L; the current density: about 15 ASF; time: 6 min; gold plating solution (NT-1000, provided by Auromex Co., Ltd.).
(8) Electroless nickel immersion gold test:
   (a) Electroless nickel plating: temperature: 85°C; time: 60 minutes Electroless nickel plating bath solution (NIMUDEM NPR-4, provided by Uyemura Co., Ltd)
   (b) Immersion Gold: temperature: 85°C; time: 15 minutes Immersion gold plating bath solution (AURICAL TTT-24, provided by Uyemura Co., Ltd)

### Test Results

**TABLE 3: test results of physical properties**

| | Examples 6 | | | | | | Comparative example | | | | | | | |
|---|---|---|---|---|---|---|---|---|---|---|---|---|---|---|
| Thin | 1 | 2 | 3 | 4 | 5 | 6 | 1 | 2 | 3 | 4 | 5 | 6 | 7 | 8 |
| line adhesion (x 2BT) | 25 microns | 30 microns | 20 microns | 20 microns | 20 microns | 20 microns | 30 microns | 30 microns | 45 microns | 45 microns | 50 microns | 45 microns | 45 microns | 45 microns |
| Thin line adhesion of alkaline etching | 60 microns | 70 microns | 60 microns | 60 microns | 60 microns | 60 microns | 100 microns | 90 microns | >100 microns | >100 microns | >100 microns | >100 microns | >100 microns | >100 microns |
| Gold plating | PASS | PASS | PASS | PASS | PASS | PASS | stripped | stripped | stripped | stripped | stripped | stripped | stripped | stripped |
| Electroless nickel plating immersion gold | PASS | PASS | PASS | PASS | PASS | PASS | stripped | stripped | stripped | stripped | stripped | stripped | stripped | stripped |

| | | | | | | | | | | | | | | |
|---|---|---|---|---|---|---|---|---|---|---|---|---|---|---|
| *PASS: unstripped | | | | | | | | | | | | | | |

As evidenced from the test results, the compositions of Examples 1 to 6, wherein the polymerized units of the polymeric binder component comprise suitable amounts of benzyl (meth)acrylate, have alkaline etching resistance, gold plating resistance, electroless plating nickel immersion gold resistance, and obtain a good resolution when developed in an alkaline aqueous solution due to their good alkaline resistance. On the contrary, the compositions of Comparative Examples 3 and 4, in which the polymerized units of the polymeric binder contain no benzyl (meth)acrylate, show poor physical properties, for example, poor thin line adhesion and poor developing resolution, as evidenced by the test results. Therefore, it is found from the test results on physical properties in TABLE 3 that when the polymerized units of the polymeric binder comprise benzyl (meth)acrylate, the resultant compositions possess gold plating resistance and electroless plating nickel immersion gold resistance, and may impart a good etching resistance to the photoimageable compositions of the invention because of the presence of a benzene ring.

## Claims

1. A photoimageable composition comprising, based on the total weight of the photoimageable composition:
(A) from 30 to 80 wt% of a polymeric binder;
(B) from 5 to 50 wt% of a photopolymerizable compound; and
(C) from 1.5 to 20 wt% of a photoinitiator,
wherein the polymeric binder of component (A) contains as a polymerized unit at least one monomer of the structure of formula (1), in an amount of from 5 to 35 wt%, based on the total weight of the polymeric binder, 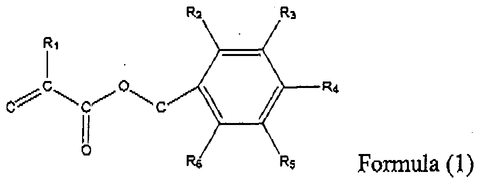 wherein, R₁ is H or methyl; and
R₂, R₃, R₄, R₅ and R₆ independently represent H, a halogen, or a substituted or unsubstituted C₁ to C₁₀ alkyl,

2. The composition according to claim 1, wherein the monomer of formula (1) is benzyl (meth)acrylate.

3. The composition according to any one of the preceding claims, wherein the photopolymerizable compound is an α,β-ethylenically unsaturated compound.

4. The composition according to any one or the preceding claims, wherein the weight average molecular weights of component (A) range from 20,000 to 200,000.

5. The composition according to claim 4, wherein the weight average molecular weights of component (A) range from 35,000 to 120,000.

6. The composition according to any one of the preceding claims, which comprises an additive selected from a dye, a stabilizer, a coupler, a flexibilizing agent, a filler, or a combination of two or more thereof.

7. Use of the composition according to any one of claims 1 to 6 in the manufacture of a printed circuit board.

8. A process for the manufacture of a printed circuit board, which process comprises:
(i) using the composition according to any one of claims 1 to 6 to form a layer on a copper-clad board;
(ii) covering the said layer with a photomask;
(iii) exposing the uncovered area of the said layer to actinic radiation;
(iv) developing the non-irradiated area of the said layer with an aqueous alkaline solution; and
(v) etching the resulting uncovered copper with an alkaline etchant.

9. A process according to claim 8, which process comprises:
(vi) removing the remaining areas of the layer of the composition according to any one of claims 1 to 6 using a stripper.

## Patentansprüche

1. Photostrukturierbare Zusammensetzung, die, basierend auf dem Gesamtgewicht der photostrukturierbaren Zusammensetzung, umfasst:
(A) von 30 bis 80 Gew.% eines polymeren Bindemittels;
(B) von 5 bis 50 Gew.% einer photopolymerisierbaren Verbindung; und
(C) von 1,5 bis 20 Gew.% eines Photoinitiators,
wobei das polymere Bindemittel der Komponente (A)als eine polymerisierte Einheit mindestens ein Monomer der Struktur der Formel (1), in einer Menge von 5 bis 35 Gew.%, basierend auf dem Gesamtgewicht des polymeren Bindemittels, enthält, 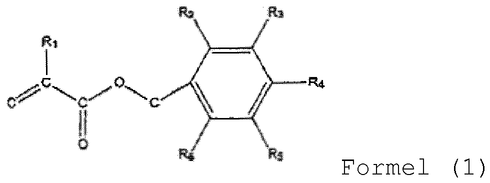 worin R₁ H oder Methyl ist; und
R₂, R₃, R₄, R₅ und R₆ unabhängig H, ein Halogen oder ein substituiertes oder unsubstituiertes C₁ bis C₁₀-Alkyl darstellten.

2. Zusammensetzung gemäß Anspruch 1, wobei das Monomer der Formel (1) Benzyl (meth) acrylat ist.

3. Zusammensetzung gemäß einem der vorangehenden Ansprüche, wobei die photopolymerisierbare Verbindung eine α,β-ethylenisch ungesättigte Verbindung ist.

4. Zusammensetzung gemäß einem der vorangehenden Ansprüche, wobei die gewichtsmittleren Molekulargewichte der Komponente (A) von 20.000 bis 200.000 reichen.

5. Zusammensetzung gemäß Anspruch 4, wobei die gewichtsmittleren Molekulargewichte der Komponente (A) von 35.000 bis 120.000 reichen.

6. Zusammensetzung gemäß einem der vorangehenden Ansprüche, die ein Additiv, ausgewählt aus einem Farbstoff, einem Stabilisator, einer Kupplungskomponente, einem Flexibilisierungsmittel, einem Füllstoff oder einer Kombination aus zwei oder mehr davon, umfasst.

7. Verwendung der Zusammensetzung gemäß einem der Ansprüche 1 bis 6 bei der Herstellung einer Leiterplatte.

8. Verfahren für die Herstellung einer Leiterplatte, wobei das Verfahren umfasst:
(i) Verwenden der Zusammensetzung gemäß einem der Ansprüche 1 bis 6, um eine Schicht auf einer kupferplattierten Platte zu bilden;
(ii) Bedecken der genannten Schicht mit einer Photomaske;
(iii) Aussetzen des unbedeckten Bereichs der genannten Schicht aktinischer Strahlung;
(iv) Entwickeln des nicht-bestrahlten Bereichs der genannten Schicht mit einer wässrigen alkalischen Lösung; und
(v) Ätzen des resultierenden nicht-bedeckten Kupfers mit einem alkalischen Ätzmittel.

9. Verfahren gemäß Anspruch 8, wobei das Verfahren umfasst:
(vi) Entfernen der verbleibenden Bereiche der Schicht der Zusammensetzung gemäß einem der Ansprüche 1 bis 6 unter Verwendung eines Ablösers.

## Revendications

1. Composition photosensible comprenant, par rapport au poids total de cette composition photosensible :
A) de 30 à 80 % en poids d'un liant polymère,
B) de 5 à 50 % en poids d'un composé photopolymérisable,
C) et de 1,5 à 20 % en poids d'un photoamorceur,
dans laquelle composition le liant polymère (composant A) comporte, en tant que motif unitaire polymérisé, en une proportion de 5 à 35 %, en poids rapporté au poids total du liant polymère, au moins un monomère de structure représentée par la formule (1) : 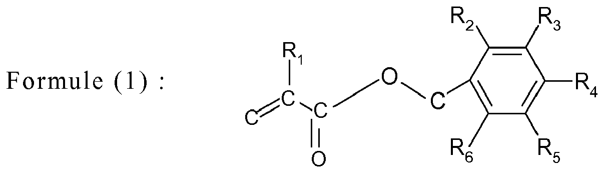 dans laquelle
- R₁ représente un atome d'hydrogène ou un groupe méthyle,
- et R₂, R₃, R₄, R₅ et R₆ représentent chacun, indépendamment, un atome d'hydrogène ou d'halogène ou un groupe alkyle en C₁-C₁₀, avec ou sans substituant(s).

2. Composition conforme à la revendication 1, dans laquelle le monomère de formule (I) est de l'acrylate de benzyle ou du méthacrylate de benzyle.

3. Composition conforme à l'une des revendications précédentes, dans laquelle le composé photopolymérisable est un composé à insaturation α,β-éthylénique.

4. Composition conforme à l'une des revendications précédentes, dans laquelle la masse molaire moyenne en poids du composant A vaut de 20 000 à 200 000.

5. Composition conforme à la revendication 4, dans laquelle la masse molaire moyenne en poids du composant A vaut de 35 000 à 120 000.

6. Composition conforme à l'une des revendications précédentes, qui comprend un adjuvant choisi parmi un colorant, un stabilisant, un coupleur, un agent de flexibilisation et une charge, ou une combinaison de deux de ces adjuvants ou plus.

7. Utilisation d'une composition conforme à l'une des revendications 1 à 6 dans la fabrication de cartes à circuit imprimé.

8. Procédé de fabrication d'une carte à circuit imprimé, lequel procédé comporte les étapes suivantes :
i) utiliser une composition conforme à l'une des revendications 1 à 6 pour en faire une couche sur un substrat plaqué cuivre ;
ii) recouvrir cette couche avec un masque de photogravure ;
iii) exposer les zones non recouvertes de ladite couche à un rayonnement actinique ;
iv) développer les zones non irradiées de ladite couche avec une solution aqueuse alcaline ;
v) et attaquer le cuivre découvert résultant avec un réactif d'attaque alcalin.

9. Procédé conforme à la revendication 8, lequel procédé comporte l'étape suivante :
vi) enlever, à l'aide d'un agent éliminateur, les zones restantes de la couche de composition conforme à l'une des revendications 1 à 6.
